# EUROPÄISCHE PATENTSCHRIFT

(11) **EP 1 393 609 B1**
(45) Veröffentlichungstag und Bekanntmachung des Hinweises auf die Patenterteilung: **02.02.2005**
(21) Anmeldenummer: 02729912.2
(22) Anmeldetag: 24.05.2002
(51) Int. Cl.: H05K 13/04

(54) **BESTÜCKKOPF MIT EINER PNEUMATISCHEN DRUCKSTEUEREINRICHTUNG SOWIE VERFAHREN ZUM BETRIEB DES BESTÜCKKOPFES**
ASSEMBLY HEAD COMPRISING A PNEUMATIC PRESSURE CONTROL DEVICE AND METHOD FOR OPERATING SAID ASSEMBLY HEAD
TETE DE MONTAGE COMPRENANT UN SYSTEME DE COMMANDE DE PRESSION PNEUMATIQUE ET PROCEDE POUR EXPLOITER CETTE TETE DE MONTAGE

(30) Priorität: 07.06.2001 DE 10127734
(43) Veröffentlichungstag der Anmeldung: 03.03.2004
(73) Patentinhaber: SIEMENS AKTIENGESELLSCHAFT, 80333 München (DE)
(72) Erfinder: DÜBEL, Rainer, 85598 Baldham (DE)
(86) Internationale Anmeldenummer: PCT/DE2002/001921
(87) Internationale Veröffentlichungsnummer: WO 2002/100134

(56) Entgegenhaltungen:
- US-A- 5 285 946
- US-B1- 6 178 621

## Beschreibung

Die Erfindung bezieht sich auf einen Bestückkopf mit mindestens einer wechselbaren Pipette zum Ansaugen eines elektrischen Bauelementes, wobei die Pipette an eine mit einem Drucksensor verbundene pneumatische Leitung angeschlossen ist, wobei die Leitung zumindest temporär an ein feinstufig zwischen Über- und Unterdruck verstellbares Steuerventil anschließbar ist.

Durch die EP 0 879 550 B1 ist es bekannt, das Steuerventil als mechanisch betätigtes Umschaltventil auszubilden, durch das die Pipette wahlweise mit Vakuum oder Druckluft verbunden werden kann. Dabei ist es üblich, für die verschiedenen Pipettentypen Schwellwerte des Vakuums abzuspeichern, um das Vorhandensein oder Fehlen eines Bauteils feststellen zu können. Pipetten für sehr kleine Bauelemente haben entsprechend kleine Saugöffnungen, bei denen die Druckdifferenz zwischen dem geöffneten und dem verschlossenen Saugkanal sehr gering ist. Bereits geringfügige Veränderungen des Umgebungsdrucks oder des Saugquerschnitts bei Verschmutzung führen zu Erkennungsfehlern, die sich in einer fehlerhaften Betriebsweise der Bestückvorrichtung niederschlagen.

Ferner ist durch die EP 0906 010 A ein Bestückkopf mit Saugpipetten bekannt geworden, die jeweils an eine Vakuumstrahlpumpe angeschlossen sind. Durch Verengen des Abluftquerschnitts der Pumpe mittels einer verstellbaren Drossel kann der Nutzdruck im Saugkanal bis in den Überdruckbereich hinein erhöht werden. Die Drosselstellung kann mittels eines steuerbaren Antriebs beeinflusst werden. Mit der Saugleitung ist ein Drucksensor verbunden, dessen Meßwerte überwacht werden und die Drosselstellung beeinflussen.

Der Erfindung liegt die Aufgabe zugrunde, die Betriebssicherheit der Bestückvorrichtung zu erhöhen.

Diese Aufgabe wird durch die Erfindung gemäß Anspruch 1 gelöst. Durch das verstellbares Regelventil ist es möglich, das jeweils vorgegebene Druckniveau auf einen Wert einzustellen, bei dem auch bei kleinen Bauelementen und kleinen Saugquerschnitten hinreichende Druckunterschiede zwischen der belegten und freien Pipette entstehen, so dass auch bei veränderten Saugbedingungen eine sichere Abfrage möglich ist. Da die unterschiedlichen Bauelemente beim Ansaugen aus einem Bauteilegurt unterschiedlichen Bedingungen unterworfen sind, ist es ferner möglich, das Vakuum diesen unterschiedlichen Bedingungen zusätzlich anzupassen.

Beim Aufsetzen des Bauelements auf eine Leiterplatte kann das Regelventil aus einer Unterdruck- in eine Überdruckstellung verändert werden, um das aufgesetzte Bauelement mit einem Überdruckimpuls sicher von der Pipette zu lösen. Um dabei die Aufsetzlage des Bauelements nicht zu gefährden, ist es möglich, auch den Blasdruck dem jeweiligen Pipetten- und Bauteiletyp anzupassen. Die entsprechenden Einstellwerte können durch Probeläufe des Bestückkopfes ermittelt werden.

Besonders vorteilhaft ist die Erfassung der Druckwerte in engen Zeitabständen und der daraus ermittelte Druckverlauf. Beim Abholen äußert sich das Fehlen eines Bauteiles in einem scharfen Knick der Druckkurve während des Vakuumaufbaues, wobei der Kurvengradient sprungartig von Plus nach Minus wechselt. Auf diese Weise kann der Pipettenstatus zu einem frühestmöglichen Zeitpunkt erkannt werden, um den Ansaugvorgang kurzfristig wiederholen zu können.

Vorteilhafte Weiterbildungen der Erfindung sind in Unteransprüchen gekennzeichnet:

Durch die Weiterbildung nach Anspruch 2 wird der Regelkreis innerhalb des Regelventils mit entsprechend kurzem Regelzyklus gebildet. Der Sensor und das Regelventil bilden eine integrierte Einheit mit definierten Leitungsverhältnissen und entsprechender Genauigkeit unter Wegfall eines zusätzlichen Sensors.

Durch die Weiterbildung nach Anspruch 3 wird der Pipettenstatus unabhängig von Absolutdrücken erfasst, indem z. B. der Saugdruck vor und nach dem Ansaugen bzw. Aufsetzen eines Bauelements verglichen wird.

Die Strahlpumpe nach Anspruch 4 stellt ein einfaches, schnell und genau zu regelndes kompaktes Bauteil dar, wobei das als Rückstaudrossel dienende Stellglied durch den steuerbaren Antrieb mit Hilfe der Wegmess-Einrichtung besonders rapide und genau in die vorgesehene Regelposition verstellt werden kann.

Durch die Weiterbildung nach Anspruch 5 wird das anliegende permanente Vakuum ohne dieses abzuschalten, in sehr kurzer Umschaltzeit modifiziert bzw. überkompensiert, um im Moment des Aufsetzens einen zeitlich eng begrenzten Druckluftimpuls erzeugen zu können.

Die Weiterbildung nach Anspruch 6 bezieht sich auf einen sogenannten Revolverbestückkopf, bei dem bisher für jede Pipette ein eigenes Ventil benötigt wurde, um einen gezielten Druckluftimpuls ausgeben zu können. Durch die Überlagerungssteuerung ist es nun nicht mehr erforderlich, das Vakuum abzuschalten, so dass auf die einzelnen Ventile verzichtet werden kann. Dabei wird lediglich dafür gesorgt, dass die zum Ventil führenden Kanäle außerhalb der Aufsetzposition durch den Schieber abgedichtet sind und lediglich in der Aufsetzposition mit dem Regelventil verbunden sind. Dabei kann durch die Leitungsgeometrie im Bereich der Verzweigung sowie durch die Steuerung des Druckimpulses dafür gesorgt werden, dass sich dieser nicht auf die Druckverhältnisse in den anderen Pipetten auswirkt.

Das von den anderen Pipetten durch den Schieber getrennte Regelventil kann ein so starkes Vakuum erzeugen, daß beim Abholen des Bauelements ein maximaler Saugdruck sicher erreicht wird unabhängig davon, ob das Vakuum in den anderen Pipetten zwischen höheren und niedrigerem Niveau bei voller oder geringer Belegung mit Bauelementen schwankt.

Durch den Drucksensor nach Anspruch 7 kann das an der Pipette anliegende Vakuum genau kontrolliert werden. Die Druckmessung erfolgt jeweils nach dem Abheben und nach dem Aufnehmen des Bauelements, wobei die gemessenen Druckwerte in der Steuerung gespeichert und verglichen werden können. Dadurch ist es möglich, festzustellen, ob das betreffende Bauelement bestimmungsgemäß aufgenommen bzw. abgegeben wurde. Weiterhin ist es auch möglich, den Druckwert einer unverschmutzten Pipette abzuspeichern und mit den aktuellen Werten der jeweils leeren Pipette zu vergleichen. Auf diese Weise kann auch der Verschmutzungsgrad der Pipette an der Saugöffnung bzw. im Saugkanal überwacht werden, um die Pipette rechtzeitig austauschen zu können.

Durch das Verfahren nach den Ansprüchen 8 und 9 lassen sich die besonders kritischen Zustände des Bestückkopfes sicher überwachen.

Im Folgenden wird die Erfindung anhand eines in der Zeichnung dargestellten Ausführungsbeispieles näher erläutert.
- Figur 1: zeigt schematisiert einen bekannten Bestückkopf,
- Figur 2: in ähnlicher Weise einen Bestückkopf nach der Erfindung
- Figur 3: eine Druck-Zeitdiagramm an einer Saugöffnung einer Pipette.

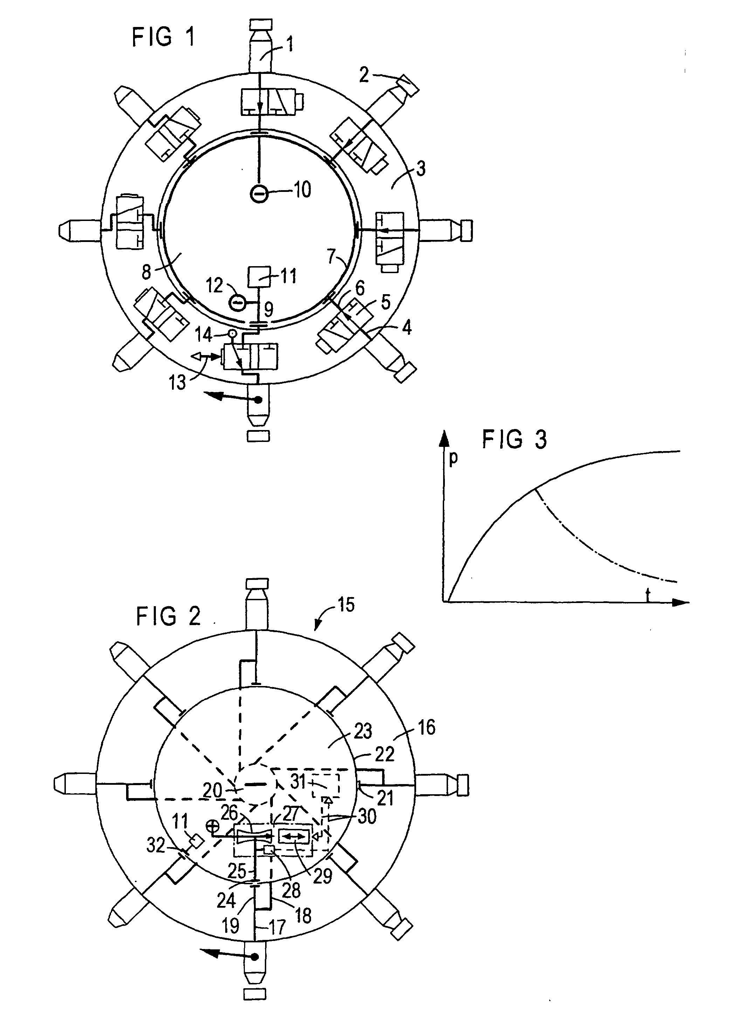

Nach Figur 1 weist ein revolverartiger Bestückkopf sternförmig abstehende Pipetten 1 zum Ansaugen von Bauelementen 2 auf. Die Pipetten sind an einem Rotor 3 gelagert und an je eine pneumatische Leitung 4 angeschlossen, die in ein Umschaltventil 5 mündet. Von diesen führen Saugleitungen 6 zu einem drehschieberartigen Verteiler 7.

Der Rotor 3 ist in der Richtung des Drehpfeiles schrittweise derart verdrehbar, dass jeweils eine der Pipetten 1 in eine Aufsetzposition gelangt, in der das Bauteil 2 auf eine Leiterplatte aufgesetzt bzw. aus einem Bauteilevorrat entnommen werden kann. Der Verteiler 7 befindet sich an der Schnittstelle zwischen dem Rotor 3 und einem Stator 8 und ist so gestaltet, dass jeweils die in der Aufsetzposition befindliche Saugleitung 6 temporär mit einer stationären Steuerleitung 9 verbunden ist. Die übrigen Saugleitungen 6 sind mit einer permanenten Vakuumquelle des Stators 8 verbunden. An die Steuerleitung 9 ist ein Drucksensor 11 angeschlossen, mit dem der Druck in der Saugleitung 6 überwacht werden kann.

Die Steuerleitung 9 endet in einem Schaltventil 12, über das sie schaltbar mit einer weiteren Vakuumquelle 10 verbunden werden kann. Die Umschaltventile 5 sind mittels eines stationären mechanischen Antriebs 13 betätigbar und verbleiben während des weiteren Umlaufes in der jeweils gewählten Schaltstellung. Vor dem Aufsetzen der Bauelemente 2 stehen die Umschaltventile auf Durchgang, so dass die Pipetten 1 an das permanente Vakuum angeschlossen sind. Das Schaltventil 12 ist während der Aufsetzphase ebenfalls auf Vakuum geschaltet, so dass auch die zugehörige Pipette 1 mit Vakuum versorgt ist.

Das in der Aufsetzstellung befindliche Umschaltventil 5 ist außerdem temporär mit einer Druckluftquelle 14 verbunden. Der mechanische Antrieb 13 schaltet nach dem Aufsetzen des Bauelements 2 auf die Leiterplatte das Umschaltventils 5 auf die Druckluftquelle 14, aus der ein kurzer Druckluftimpuls abgegeben wird, der das Bauelement 2 sicher von der Pipettenspitze ablöst. Das Umschaltventil 5 bleibt sodann in dieser Schaltstellung, in der die Pipette entlüftet und das Vakuum abgeschaltet ist.

Beim Abholen der Bauelemente 2 schaltet der Antrieb 13 das Umschaltventil 5 in die andere Stellung, in der die pneumatische Leitung 4 mit der am Vakuum liegenden Steuerleitung 9 verbunden ist. Dadurch wird das Bauelement 2 angesaugt. Da das Umschaltventil beim Weiterdrehen in den Haltekreis der Vakuumversorgung in dieser Schaltstellung verbleibt, bleibt auch die Pipette weiter unter Vakuum. Nach dem Ansaugen des Bauelements 2 an die in der Aufsetzposition befindliche Pipette 1 stärkt sich das Vakuum in der Steuerleitung 9 über einen vorgegebenen Schwellwert. Dieser Vorgang wird vom Drucksensor 11 detektiert und als korrekt bewertet. Wird hingegen die Vakuumschwelle nicht überschritten, so erkennt eine Auswerte-Einrichtung das Bauteil als nicht korrekt aufgenommen. Da die Pipetten 1 mit ihren Saugöffnungen unterschiedlich großen Bauelementen angepasst sind, ergeben sich insbesondere bei kleinen Bauteilen geringe Druckunterschiede, die durch die Wirkung von Umwelteinflüssen überlagert werden können, so dass eine sichere Auswertung nicht möglich ist. Kann ein Bauteil nicht abgeholt werden oder wird es später verloren, so kann dieses Leck die Vakuumleistung der Vakuumquelle 10 verringern.

Nach Figur 2 ist ein erfindungsgemäß modifizierter Bestückkopf 15 ebenfalls mit den an einem Rotor 16 sternförmig abstehenden Pipetten 1 versehen. Die Pipetten 1 sind an jeweils eine pneumatische Leitung 17 angeschlossen, die sich in eine Saugleitung 18 und eine Steuerleitung 19 verzweigt. Sämtliche Saugleitungen 18 sind permanent an eine zentrale Vakuumleitung 20 des Rotors 16 unmittelbar angeschlossen.

Die Steuerleitungen 19 münden in je einer Öffnung 21 des Rotors 16, die durch einen zirkulären Schieber 22 eines Stators 23 verschlossen ist. Dieser weist an der unteren Aufsetzposition der Pipetten 1 eine einer zur Öffnung 21 komplementäre Schieberöffnung 24 auf, die über eine stationäre Steuerleitung 25 mit einer als Venturidüse ausgebildeten Strahlpumpe 26 eines Regelventils 27 des Stators 23 verbunden ist. Das Regelventil 27 weist einen an die stationäre Leitung 25 angeschlossen Sensor 28 zur Überwachung des Nutzdrucks in der Steuerleitung 25 bzw. 19 auf.

Die Ausström-Öffnung der Strahlpumpe 26 ist durch ein mechanisch angetriebenes Stellglied 29 derart veränderbar, dass der Druck in der stationären Steuerleitung 25 feinstufig verändert werden kann. Der Sensor 28 und der mechanische Antrieb sind über elektrische Leitungen 30 mit einer elektronischen Steuerung 31 verbunden, in der den unterschiedlichen Pipettentypen und/oder Bauteiletypen zugeordnete Druckwerte gespeichert sind.

Beim Aufsetzen des Bauelements 2 auf eine Leiterplatte kann der Nutzdruck in der Steuerleitung 19 so stark erhöht werden, so dass er das Vakuum der Saugleitung 18 in der pneumatischen Leitung 17 überlagert, so dass ein in Stärke und Dauer geregelter Druckluftimpuls auf das Bauteil ausgegeben werden kann, um dieses sicher von der Pipette 1 abzulösen und auf die Leiterplatte aufzusetzen, wobei die Saugleistung der Vakuumquelle 20 so groß ist, dass in der Saugleitung 18 ein stabiles Vakuum gewährleistet ist. Dadurch ist es auch möglich, ein Aufnehmen eines Bauelements 2 aus einer Zuführeinrichtung den Saugdruck in der pneumatischen Leitung 17 mittels des Sensors 28 zu überwachen.

Die Verzweigungsgeometrie zwischen der Saugleitung 18 und der Steuerleitung 19 kann weitgehend neutralisierend gestaltet sein, so daß das Vakuum der Saugleitung 18 die Verhältnisse in der Steuerleitung 19 kaum beeinflußt und daß der kurze Druckimpuls der Steuerleitung 19 nur gering in Saugleitung 18 eingekoppelt wird.

Der zirkuläre Schieber 22 weist in einer weiteren Haltestation des Rotors 16 eine weitere Schieberöffnung 32 auf, an die der stationäre Drucksensor 11 angeschlossen ist, mit dem das an der Pipette anliegende Vakuum genau kontrolliert werden kann. Die Druckmessung erfolgt jeweils nach dem Abheben und nach dem Aufnehmen des Bauelements 2, wobei die gemessenen Druckwerte in der Steuerung 31 gespeichert und verglichen werden können. Dadurch ist es möglich, festzustellen, ob das betreffende Bauelement 2 bestimmungsgemäß aufgenommen bzw. abgegeben wurde. Weiterhin ist es auch möglich, den Druckwert einer unverschmutzten Pipette abzuspeichern und mit den aktuellen Werten der jeweils leeren Pipette zu vergleichen. Auf diese Weise kann auch der Verschmutzungsgrad der Pipette (1) an der Saugöffnung bzw. im Saugkanal überwacht werden, um die Pipette (1) rechtzeitig austauschen zu können.

Figur 3 zeigt den Vakuumverlauf p über der Zeit t beim Abholen eines Bauteils. Zunächst setzt die Pipette auf das Bauteil auf, wodurch die Saugöffnung an der Pipettenspitze verschlossen wird. Daraufhin verstärkt sich das Vakuum entsprechend der durchgezogenenen Kurve und nähert sich einem Maximalwert an. Die strichpunktierte Kurve ergibt sich in dem Fall, dass das Bauteil nicht erfasst worden ist. Solange die Pipettenspitze auf dem Bauteil aufgesetzt bleibt, kommt es im linken Kurvenbereich zum normalen Druckverlauf. Sobald jedoch die Pipette vom Bauteil abhebt, ergibt sich der strichpunktiert dargestellte Vakuumabfall, der sich einem Minimum annähert. Die Steuerung wertet den Druckverlauf in engen Zeitabständen aus und errechnet die jeweilige Kurvensteigung. Dabei ergibt die strichpunktierte Kurve einen Gradienten mit umgekehrtem Vorzeichen. Diese deutliche Änderung wird als Bauteileverlust bewertet und löst einen erneuten Abholversuch aus.

## Patentansprüche

1. Bestückkopf (15) mit mindestens einer wechselbaren Pipette (1) zum Ansaugen eines elektrischen Bauelementes (2),
- wobei die Pipette (1) an eine mit einem Drucksensor (11) verbundene pneumatische Leitung (17) angeschlossen ist
- wobei die Leitung (17) zumindest temporär an ein feinstufig zwischen Über- und Unterdruck verstellbares Regelventil (27) anschließbar ist
**dadurch gekennzeichnet,**
- **dass** die Druckwerte der Leitung (17) in engen Zeitabständen ermittelbar sind
- **dass** daraus aus den Druckdifferenzen in Abhängigkeit von den Zeitintervallen errechnete Steigungen und Steigungsänderungen des Druckverlaufs als Kriterien für den jeweiligen Pipettenstatus dienen.

2. Bestückkopf nach Anspruch 1,
**dadurch gekennzeichnet,**
- **dass** das Regelventil (27) mit einem vorzugsweise integrierten Sensor (28) zum Überwachen des Nutzdrucks der pneumatischen Leitung verbunden ist und
- **dass** der Sensor (28) beim Aufnehmen und Abgeben des Bauelements (2) aktivierbar ist.

3. Bestückkopf nach Anspruch 1 oder 2,
**dadurch gekennzeichnet,**
**dass** das Regelventil (27) mit einer Steuerung (31) verbunden ist, in der unterschiedliche, den verschiedenen Pipettentypen und/oder Bauteiletypen zugeordnete Druckwerte speicherbar sind.

4. Bestückkopf nach einem der Ansprüche 1 bis 3,
**dadurch gekennzeichnet,**
- **dass** das Regelventil (27) eine Strahlpumpe (26) mit einem in einer Ausströmöffnung mündenden Hauptstromkanal und einem von diesem abzweigenden Nebenstromkanal aufweist,
- **dass** der Ausströmquerschnitt mittels eines feinstufig verstellbaren Stellglieds (29) veränderbar ist und dass das Stellglied (29) mit einem steuerbaren Antrieb verbunden ist und
- **dass** der Antrieb eine Wegmess-Einrichtung aufweist.

5. Bestückkopf nach einem der vorhergehenden Ansprüche,
**dadurch gekennzeichnet,**
- **dass** sich die Leitung in eine permanent vakuumführende Saugleitung (18) und eine mit dem Regelventil (27) verbundene Steuerleitung (19) verzweigt,
- **dass** das Regelventil (27) an eine eigene Druckversorgung angeschlossen ist und
- **dass** ein vom Regelventil ausgehender Druckimpuls derart einstellbar und in die pneumatische Leitung (17) einleitbar ist, dass er das permanent anliegende Vakuum überlagert.

6. Bestückkopf nach eine der vorhergehenden Ansprüche,
**dadurch gekennzeichnet,**
- **dass** der Bestückkopf (15) einen Stator (23) und einen schrittweise verdrehbaren Rotor (16) mit einer Mehrzahl der Pipetten (1) aufweist, von denen jeweils ein in einer Aufsetz- bzw. Abholposition bewegbar ist,
- **dass** sämtliche Pipetten (1) permanent an ihre Saugleitung (18) angeschlossen sind und
- **dass** die Steuerleitung (19) der in ihrer Aufsetzposition befindliche Pipette (1) mittels eines zirkulären Schiebers (22) über eine Schieberöffnung (24) an eine stationäre Steuerleitung (25) mit dem am Stator(23) verankerten Regelventil (27) anschließbar ist.

7. Bestückkopf nach eine der vorhergehenden Ansprüche,
**dadurch gekennzeichnet,**
- **dass** der Stator (23) in einer anderen Haltestation der Pipetten (1) einen Drucksensor (11) aufweist, der über eine weitere Schieberöffnung (32) mit der zugehörigen Steuerleitung (19) verbunden ist.

8. Verfahren zum Betreiben eines Bestückkopfes (15) mit mindestens einer Pipette (1) zum Ansaugen eins Bauelementes (2) sowie mit einem Sensor (11, 28) zur Überwachung des Druckniveaus einer zur Pipette führenden pneumatischen Leitung (17), insbesondere nach einem der vorhergehenden Ansprüche,
**dadurch gekennzeichnet,**
**dass** der Pipettenstatus anhand von in zeitlichen Abständen gemessenen Druckveränderungen erfasst wird.

9. Verfahren nach Anspruch 8,
**dadurch gekennzeichnet,**
- **dass** die Druckwerte der Leitung (17) in engen Zeitabschnitten ermittelt werden,
- **dass** daraus Steigungen und Steigungsänderungen des Druckverlaufs errechnet werden und
- **dass** diese Werte mit in der Steuerung gespeicherten, den verschiedenen Pipettentypen und/oder Bauteiletypen zugeordneten Stammdaten verglichen werden.

## Claims

1. An assembly head (15) comprising at least one replaceable pipette (1) for holding an electrical element (2) by vacuum suction,
- wherein the pipette (1) is connected to a pneumatic line (17) which is linked to a pressure sensor (11),
- wherein the line (17) can be connected at least temporarily to a control valve (27) which is finely adjustable between positive pressure and negative pressure,
**characterised in that**
- the pressure values of the line (17) can be determined at short time intervals, and
- increases and increase changes in the pressure profile, which are calculated from the pressure differences depending on the time intervals, serve as criteria for the relevant pipette status.

2. The assembly head as claimed in Claim 1,
**characterised in that**
- the control valve (27) is connected to a preferably integrated sensor (28) for monitoring the effective pressure of the pneumatic line, and
- the sensor (28) can be activated during the pickup and release of the element (2) .

3. The assembly head as claimed in Claim 1 or 2,
**characterised in that**
the control valve (27) is connected to a controller (31) in which different pressure values that are assigned to the various pipette types and/or component types can be stored.

4. The assembly head as claimed in one of the Claims 1 to 3,
**characterised in that**
- the control valve (27) includes a jet pump (26) which has a main flow channel that leads into an outflow opening and an auxiliary flow channel which branches off from said main flow channel,
- the outflow cross section can be changed by means of a finely adjustable actuator (29), and the actuator (29) is connected to controllable drive mechanism, and
- the drive mechanism has a position measuring device.

5. The assembly head as claimed in one of the preceding Claims,
**characterised in that**
- the line branches into a suction line (18), which carries a permanent vacuum, and a control line (19) which is connected to the control valve (27)
- the control valve (27) is connected to a separate pressure supply, and
- a pressure pulse originating from the control valve can be configured and introduced into the pneumatic line (17) in such a way that it overlays the vacuum which is permanently present.

6. The assembly head as claimed in one of the preceding Claims,
**characterised in that**
- the assembly head (15) has a stator (23) and a rotor (16) which can be rotated step-by-step and includes a plurality of the pipettes (1), of which one in each case can be moved into a placement position or pickup position,
- all pipettes (1) are permanently attached to their suction line (18), and
- the control line (19) of the pipette (1) which is situated in its placement position can be attached by means of a circular slide (22) via a slide opening (24) at a stationary control line (25) to the control valve (27) which is fixed to the stator (23).

7. The assembly head as claimed in one of the preceding Claims,
**characterised in that**
- the stator (23) has a pressure sensor (11) at a further holding station of the pipettes (1), said pressure sensor being connected to the associated control line (19) via a further slide opening (32).

8. A method for operating an assembly head (15) which has at least one pipette (1) for holding an element (2) by vacuum suction, and has a sensor (11, 28) for monitoring the pressure level of a pneumatic line (17) which leads to the pipette, in particular according to one of the preceding claims
**characterised in that**
the pipette status is captured with reference to pressure changes which are measured at time intervals.

9. The method as claimed in Claim 8,
**characterised in that**
- the pressure values of the line (17) are determined in short time slots,
- increases and increase changes in the pressure profile are calculated therefrom,
- these values are compared with base data which is stored in the controller and is assigned to the different pipette types and/or component types.

## Revendications

1. Tête de montage (15) dotée d'au moins une pipette remplaçable (1) pour aspirer un composant électrique (2),
- la pipette (1) étant raccordée à un conduit pneumatique (17) relié à une sonde de pression (11),
- le conduit (17) pouvant être raccordé au moins temporairement à une soupape de réglage (27) qui peut être commutée par gradins fins entre une surpression et une dépression,
**caractérisée en ce que**
- les valeurs de pression du conduit (17) sont détectables à de courts intervalles de temps et
- **en ce que** les pentes et les modifications de la pente de la courbe de pression calculées à partir des différences de pression en fonction des intervalles de temps servent de critères de l'état instantané de la pipette.

2. Tête de montage selon la revendication 1,
**caractérisée en ce que**
- la soupape de réglage (27) est reliée à une sonde (28), de préférence intégrée, pour la surveillance de la pression utile du conduit pneumatique et
- la sonde (28) peut être activée lors de la réception et de la libération du composant (2).

3. Tête de montage selon les revendications 1 ou 2,
**caractérisée en ce que**
la soupape de réglage (27) est reliée à une commande (31) dans laquelle différentes valeurs de pression associées à différents types de pipettes et/ou à différents types de composants peuvent être conservées en mémoire.

4. Tête de montage selon l'une des revendications 1 à 3,
**caractérisée en ce que**
- la soupape de réglage (27) présente une pompe à injecteur (26) dotée d'un canal principal d'écoulement qui débouche dans une ouverture de sortie et d'un canal d'écoulement secondaire qui en est dérivé,
- la section transversale de sortie peut être modifiée au moyen d'un organe de commande (29) qui peut être déplacé par gradins fins et **en ce que** l'organe de commande (29) est relié à une commande asservie et
- l'entraînement présente un dispositif de mesure du déplacement.

5. Tête de montage selon l'une des revendications précédentes,
**caractérisée en ce que**
- le conduit se ramifie en un conduit d'aspiration (18) qui conduit le vide en permanence et en un conduit pilote (19) relié à la soupape de réglage (27),
- la soupape de réglage (27) est raccordée à une alimentation en pression propre et
- une impulsion de pression délivrée par la soupape de réglage peut être réglée et introduite dans le conduit pneumatique (17) de telle sorte qu'elle se superpose au vide appliqué en permanence.

6. Tête de montage selon l'une des revendications précédentes,
**caractérisée en ce que**
- la tête de montage (15) présente un stator (23) et un rotor (16) qui peut tourner pas-à-pas et doté d'une pluralité de pipettes (1) qui peuvent être placées chacune à leur tour dans une position de placement ou une position d'enlèvement,
- toutes les pipettes (1) sont raccordées en permanence à leur conduit d'aspiration (18) et
- par l'intermédiaire d'une ouverture (24) d'un coulisseau circulaire (22) qui est ménagée sur un conduit pilote stationnaire (25), le conduit pilote (19) de la pipette (1) située en position de placement peut être raccordé à la soupape de réglage (27) ancrée sur le stator (23).

7. Tête de montage selon l'une des revendications précédentes,
**caractérisée en ce que**
- dans un autre poste de maintien des pipettes (1), le stator (23) présente une sonde de pression (11) qui est reliée par une autre ouverture (32) du coulisseau au conduit pilote (19) associé.

8. Procédé d'utilisation d'une tête de montage (15) dotée d'au moins une pipette (1) pour aspirer un composant (2) ainsi que d'une sonde (11, 28) pour la surveillance du niveau de pression dans un conduit pneumatique (17) qui conduit à la pipette, en particulier selon l'une des revendications précédentes,
**caractérisé en ce que**
l'état de la pipette est détecté à l'aide de modifications de la pression mesurée à intervalles de temps.

9. Procédé selon la revendication 8,
**caractérisé en ce que**
- les valeurs de pression du conduit (17) sont détectées à de courts intervalles de temps,
- à partir d'elles, on calcule des pentes et des modifications de la pente de la courbe de pression et
- ces valeurs sont comparées à des données d'origine qui sont conservées en mémoire dans la commande et qui sont associées aux différents types de pipettes et/ou différents types de composants.
